# EUROPÄISCHE PATENTSCHRIFT

(11) **EP 1 049 140 B1**
(45) Veröffentlichungstag und Bekanntmachung des Hinweises auf die Patenterteilung: **10.08.2005**
(21) Anmeldenummer: 00810354.1
(22) Anmeldetag: 25.04.2000
(51) Int. Cl.: H01L 21/00

(54) **Einrichtung und Verfahren zur Montage von Halbleiterchips auf einem Substrat**
Apparatus and method for mounting semiconductor chips on a substrate
Dispositif et méthode pour le montage de puces semi-conductrices sur un substrat

(30) Priorität: 30.04.1999 EP 99810367
(43) Veröffentlichungstag der Anmeldung: 02.11.2000
(73) Patentinhaber: Unaxis International Trading Ltd, 6330 Cham (CH)
(72) Erfinder: Stalder, Roland, 8050 Zürich (CH)
(74) Vertreter: Falk, Urs, Dr.

(56) Entgegenhaltungen:
- EP-A- 0 565 781
- US-A- 4 667 402

## Beschreibung

Die Erfindung betrifft eine Einrichtung zur Montage von Halbleiterchips auf einem Substrat, die geeignet ist für die Montage von Halbleiterchips, die auf einer auf einen Rahmen aufgespannten Folie haften. Die Erfindung betrifft weiter ein Verfahren zur Montage von Halbleiterchips auf einem Substrat.

Bei solchen Einrichtungen wird der Rahmen mit der Folie von einem verschiebbaren Tisch aufgenommen. Taktweise werden der Tisch verschoben, so dass ein Chip nach dem anderen an einem ersten Ort A bereitgestellt ist, und dann der bereitgestellte Chip von einem Chipgreifer aufgenommen und an einem zweiten Ort B auf einem Substrat plaziert. Mittels einer auf den ersten Ort A gerichteten Messkamera wird die Lage des bereitgestellten Chips vor der Entnahme von der Folie ausgemessen und die Abweichung der Lage von seiner Soll-Lage ermittelt und ein Korrekturvektor bestimmt. Für die Korrektur der ermittelten Abweichung sind folgende Verfahren bekannt:
1. Nach der Ermittlung der Abweichung, jedoch vor der Entnahme des bereitgestellten Chips von der Folie wird der Tisch um den Korrekturvektor verschoben. Dieses Verfahren ist auf einer von der Anmelderin auf dem Markt eingeführten Maschine implementiert.
2. Die Korrektur der Abweichung erfolgt durch eine Korrekturbewegung des Chipgreifers und/oder durch eine Korrekturbewegung des Substrates. Dieses Verfahren ist auf einer von der Anmelderin bereits angekündigten und demnächst käuflichen Maschine implementiert.

Die Entnahme des bereitgestellten Chips von der Folie wird von einem unterhalb der Folie angeordneten Chip-Auswerfer (in der Fachwelt bekannt als Die-Ejector) unterstützt. Die Entnahme des Chips erfolgt, indem die Folie vom Chip-Auswerfer mittels Vakkum angesaugt und festgehalten wird und indem anschliessend, fakultativ, eine die Folie von unten durchstossende Nadel den Chip gegen die Saugöffnung des Chipgreifers stösst.

Wenn nun gemäss dem oben genannten ersten Verfahren der Tisch um den Korrekturvektor verschoben wird, dann führt die Reibung zwischen der Folie und dem Chip-Auswerfer dazu, dass die Lage des Chips auch nach der Korrekturbewegung noch immer einige Mikrometer von der Soll-Lage abweichen kann. Die Folie liegt nämlich mit einem gewissen Gewicht auf dem Chip-Auswerfer auf. Bei kleinen Korrekturbewegungen, die nur wenige Mikrometer betragen, bewirkt die Reibung zwischen der Folie und dem Chip-Auswerfer nun, dass bei solch geringen Korrekturbewegungen die Folie der Bewegung des Tisches nicht folgt, sondern sich einfach dehnt.

Mit dem zweiten Verfahren lässt sich zwar die für die Plazierung des Chips auf dem Substrat erforderliche Genauigkeit erreichen, die Lösung ist jedoch technisch aufwendig.

Der Erfindung liegt die Aufgabe zugrunde, eine Einrichtung vorzuschlagen, die die vorhin genannten Nachteile nicht mehr aufweist.

Die Erfindung ist in den Ansprüchen 1 und 6 gekennzeichnet. Weiterbildungen der Erfindung ergeben sich aus den abhängigen Ansprüchen.

Eine Einrichtung zur Montage von Halbleiterchips auf einem Substrat, bei der die Chips auf einer in einem Rahmen eingespannten Folie an einem ersten Ort A bereitgestellt werden, umfasst einen Chipgreifer für den Transport des am ersten Ort A bereitgestellten Chips zu einem auf dem Substrat befindlichen zweiten Ort, einen verschiebbaren Tisch zur Aufnahme des Rahmens, einen am ersten Ort A unterhalb der Folie angeordneten Chip-Auswerfer, dessen der Folie zugewandte obere Fläche mit an eine Vakuumquelle angeschlossenen Bohrungen versehen ist, sowie eine auf den ersten Ort A gerichtete Messkamera zur Lageermittlung des bereitgestellten Chips. Die Korrektur einer allfälligen Lageabweichung des bereitgestellten Chips von seiner Soll-Lage erfolgt erfindungsgemäss, indem die Folie vom Chip-Auswerfer mittels Vakuum festgehalten wird und dann zumindest die der Folie zugewandte obere Fläche des Chip-Auswerfers in der parallel zur Folienunterseite verlaufenden Ebene verschoben wird.

Nachfolgend werden Ausführungsbeispiele der Erfindung anhand der Zeichnung näher erläutert.

Es zeigen:
- Fig. 1: eine Einrichtung zur Montage von Halbleiterchips 1, und
- Fig. 2: einen Chip-Auswerfer.

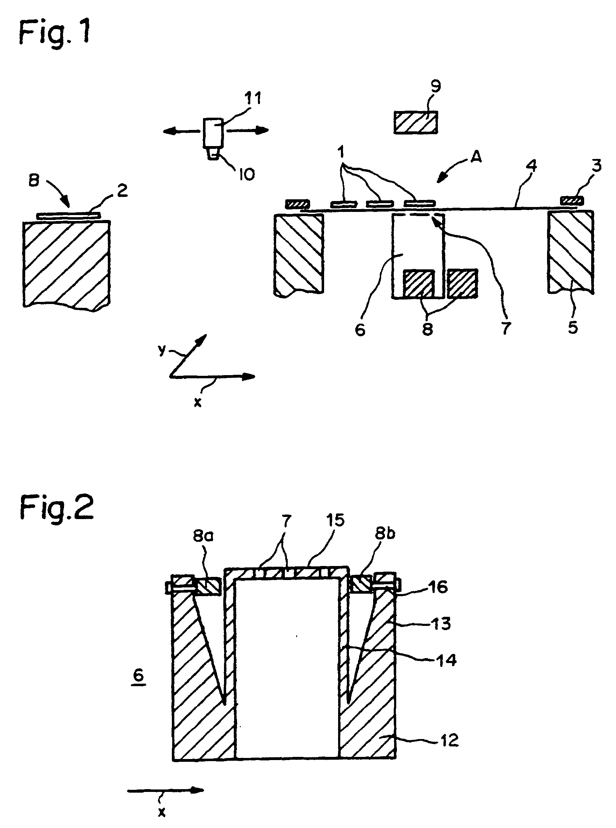

Die Fig. 1 zeigt in vereinfachter, schematischer Darstellung eine Einrichtung zur Montage von Halbleiterchips 1 auf einem Substrat 2. Die in Reihen und Kolonnen angeordneten Chips 1 haften auf einer auf einen Rahmen 3 aufgespannten Folie 4. Die Einrichtung weist einen verschiebbaren Tisch 5 auf, der den Rahmen 3 aufnimmt und einen Chip 1 nach dem anderen an einem ersten Ort A bereitstellt. Am ersten Ort A ist unterhalb der Folie 4 ein Chip-Auswerfer 6 angeordnet. Der Chip-Auswerfer 6 dient dazu, bei der Entnahme des Chips 1 dessen Ablösung von der Folie 4 zu unterstützen. Der Chip-Auswerfer 6 ist mit Bohrungen 7 versehen, die an eine Vakuumquelle angeschlossen sind. Der Chip-Auswerfer 6 ist mittels zweier Antriebe 8 in zwei orthogonalen Richtungen x und y verschiebbar. Die Folie 4 ist so angeordnet, dass die Kolonnen und Reihen der Chips 1 etwa parallel zu den Richtungen x bzw. y sind. Die Einrichtung weist weiter eine auf den ersten Ort A gerichtete Messkamera 9 zur Lageermittlung des bereitgestellten Chips 1 sowie einen Chipgreifer 10 zum Transport des am ersten Ort A bereitgestellten Chips 1 zu einem auf dem Substrat 2 befindlichen zweiten Ort B auf. Der Chipgreifer 10 ist Bestandteil eines heb- und senkbaren Bondkopfes 11. Der Bondkopf 11 und der Chipgreifer 10 werden zusammen zwischen dem Ort A und dem Ort B hin und her bewegt.

Die Einrichtung arbeitet in jedem Arbeitszyklus nach den folgenden Schritten:
1. Verschiebung des Tisches 5 zur Bereitstellung eines neuen Chips 1 am Ort A, wobei eine gewisse Lageabweichung von der Soll-Lage zulässig ist.
2. Ansaugen und Festhalten der Folie 4 durch Anlegen von Vakuum an die Bohrungen 7 des Chip-Auswerfers 6;
3. Ermittlung der Ist-Lage des Chips 1 mittels der Messkamera 9;
4. Bestimmung des Korrekturvektors, der die Abweichung der ermittelten Ist-Lage des Chips 1 von seiner Soll-Lage am Ort A darstellt;
5. Korrekturbewegung des Chip-Auswerfers 6 um den Korrekturvektor; und
6. Entnahme des Chips 1 von der Folie 4.

Die Verschiebung des Tisches 5 im Schritt 1 erfolgt aufgrund von Schätzwerten vₓ und v_{y}, die dem mittleren Abstand eines Referenzpunktes benachbarter Chips 1 in x-Richtung bzw. in y-Richtung entsprechen. Der Abstand benachbarter Chips 1 unterliegt Schwankungen, da die Folie 4 beim Einspannen des Rahmens 3 am Tisch 5 jeweils expandiert wird. Da es durchaus vorkommt, dass eine Folie 4 mehrmals im Tisch 5 eingespannt und wieder entfernt wird, weicht die im Schritt 3 ermittelte Lage des Chips 1 in x- und/oder in y-Richtung bis zu 20 µm von seiner Soll-Lage ab. Die Bereitstellung des Chips 1 am Ort A erfolgt also typischerweise mit einer Genauigkeit von etwa 20 µm.

Wenn die Chips 1 der Folie 4 wechselweise von links nach rechts und dann von rechts nach links entnommen werden, dann wird der Tisch 5 im Schritt 1 vorteilhafterweise nicht um den Vektor v=(vₓ, v_{y}), der vom Referenzpunkt des gerade abgearbeiteten Chips 1 zum Referenzpunkt des nächsten, abzuarbeitenden Chips 1 zeigt, sondern um den Vektor v + k verschoben, wobei k den Korrekturvektor des zuletzt abgearbeiteten Chips 1 bezeichnet. Es hat sich nämlich gezeigt, dass sich die maximale Abweichung der im Schritt 3 ermittelten und zu korrigierenden Lage auf etwa 5 µm reduziert, wenn bei der Verschiebung des Tisches 5 im Schritt 1 die beim vorherigen Chip 1 ermittelte Lageabweichung mitberücksichtigt wird. Die Bereitstellung des Chips 1 am Ort A erfolgt bei dieser Betriebsweise mit einer verbesserten Genauigkeit von etwa 5 µm.

Die Reihenfolge, in der die Chips 1 abgearbeitet werden, kann an der Einrichtung eingestellt werden. Die Chips 1 können, wie erwähnt, wechselweise von links nach rechts und dann von rechts nach links abgearbeitet werden. Sie können aber auch immer von links nach rechts, oder immer von oben nach unten, oder wechselweise von oben nach unten und dann von unten nach oben abgearbeitet werden. Auch bei diesen Varianten kann die maximale Abweichung der im Schritt 3 ermittelten und zu korrigierenden Lage auf etwa 5 µm reduziert werden, wenn bei der Verschiebung vom abgearbeiteten Chip 1 zum nächsten Chip 1 ein entsprechend bestimmter Korrekturvektor k verwendet wird.

Falls die Chips entsprechend vorgegebenen Kriterien und den in einer als "wafermap" bekannten Datenbank gespeicherten Angaben über die Chips in zufälliger Reihenfolge abgearbeitet werden, dann kann es vorteilhaft sein, den für den gerade abzuarbeitenden Chip ermittelten Korrekturvektor in der Datenbank zu speichern, damit er bei der Bereitstellung des nächsten Chips, der sich in der Nähe dieses Chips befindet, berücksichtigt werden kann. Die Verschiebung zum nächsten Chip kann also unter Berücksichtigung des dem Chip am nächsten liegenden Korrekturwertes erfolgen.

Für die Korrektur kleiner Lageabweichungen, die im Bereich von 0 bis etwa 5 µm liegen, kann dann ein Chip-Auswerfer 6 verwendet werden, bei dem die Korrekturbewegung mittels piezoelektrischer Antriebe 8 erfolgt. Ein solcher Chip-Auswerfer 6 ist in der Fig. 2 dargestellt. Der Chip-Auswerfer 6 weist ein Gehäuse 12 mit einer kreisrunden, starren Aussenwand 13 und einer kreisrunden, gegenüber der Aussenwand 13 beweglich ausgebildeten Innenwand 14 auf. Das Gehäuse 12 und die beiden Wände 13, 14 sind z.B. als ein Drehteil aus einem Stück gefertigt. Der Raum innerhalb der Innenwand 14 wird jeweils dann mit der Vakuumquelle verbunden, wenn die Folie 4 (Fig. 1) an der oberen Fläche 15 angesaugt und festgehalten werden soll. Zur Bewegung der oberen Fläche 15 sind zwei piezoelektrische Antriebe 8a und 8b vorgesehen, deren Ruhelage bezüglich der x-Richtung mittels Schrauben 16 einstellbar ist. Mittels der beiden Antriebe 8a und 8b ist die Innenwand 14 an ihrem der oberen Fläche 15 zugewandten Ende spielfrei mit der Aussenwand 13 verbunden. Die beiden piezoelektrische Antriebe 8a und 8b sind elektrisch gegensinnig geschaltet, so dass sie sich beim Anlegen einer Spannung zur Verschiebung der oberen Fläche 15 in x-Richtung in die gleiche Richtung bewegen. Nicht dargestellt sind zwei weitere piezoelektrische Antriebe zur Verschiebung der oberen Fläche 15 in y-Richtung. Bei einem anderen Ausführungsbeispiel ist für die Verschiebung in x-Richtung nur ein einziger piezoelektrischer Antrieb, z.B. der Antrieb 8a, vorhanden. In diesem Fall ist der Antrieb 8a sowohl mit der Aussenwand 13 wie auch mit der Innenwand 14, beispielsweise durch Kleben, fest verbunden.

Falls die ermittelte Lageabweichung nach dem Schritt 3 des obigen Verfahrens einmal grösser sein sollte, als die maximale Lageabweichung, die der Chip-Auswerfer 6 zu bewältigen vermag, dann muss anstelle des Schrittes 4 das Vakuum wieder gelöst und das Verfahren nochmals mit dem Schritt 1 begonnen werden, wobei im Schritt 1 der Tisch 5 um den aus der Lageabweichung ermittelten Korrekturvektor verschoben wird.

Die beschriebene Einrichtung eignet sich vor allem für Montageautomaten, bei denen das Substrat 2 (Fig. 1) in Vorschubrichtung mit ausreichender Genauigkeit am Ort B, an dem der Chipgreifer 10 den Chip absetzt, plaziert wird, oder bei der eine allfällige Abweichung der Lage des Substrates 2 von seiner Soll-Lage mit der für den Vorschub des Substrates 2 vorgesehenen Einrichtung korrigiert werden kann.

Um allfällige Lageabweichungen der auf dem Substrat 2 plazierten Chips 1 möglichst klein zu halten, ist es weiter möglich, mittels einer zweiten Messkamera die Lage der auf dem Substrat 2 plazierten Chips 1 zu ermitteln, aus den allfälligen Lageabweichungen der plazierten Chips 1, vorzugsweise mit statistischen Methoden, einen weiteren Korrekturvektor h zu berechnen, der somit ein Mass für allfällige Lageabweichungen vom Ort B der auf dem Substrat (2) bereits plazierten Chips (1) darstellt, und im Schritt 5 des oben angegebenen Verfahrens eine Korrekturbewegung des Chip-Auswerfers 6 auszuführen, die der Summe des im Schritt 4 ermittelten Korrekturvektors und des Korrekturvektors h entspricht.

## Patentansprüche

1. Einrichtung zur Montage von Halbleiterchips (1) auf einem Substrat (2), wobei die Chips (1) auf einer in einem Rahmen (3) eingespannten Folie (4) an einem ersten Ort A bereitgestellt werden, mit einem Chipgreifer (10) für den Transport des am ersten Ort A bereitgestellten Chips (1) zu einem auf dem Substrat (2) befindlichen zweiten Ort, mit einem verschiebbaren Tisch (5) zur Aufnahme des Rahmens (3), mit einem am ersten Ort A unterhalb der Folie (4) angeordneten Chip-Auswerfer (6), dessen der Folie (4) zugewandte obere Fläche (15) mit an eine Vakuumquelle angeschlossenen Bohrungen (7) versehen ist, sowie einer auf den ersten Ort A gerichteten Messkamera (9) zur Lageermittlung des bereitgestellten Chips (1), **dadurch gekennzeichnet, dass** für die Korrektur einer allfälligen Lageabweichung des bereitgestellten Chips (1) von seiner Soll-Lage zumindest die der Folie (4) zugewandte obere Fläche (15) des Chip-Auswerfers (1) in der parallel zur Folienunterseite verlaufenden Ebene verschiebbar ist.

2. Einrichtung nach Anspruch 1, **dadurch gekennzeichnet, dass** pro Arbeitszyklus wenigstens die folgenden Schritte durchführbar sind
1. Verschiebung des Tisches (5) zur Bereitstellung eines neuen Chips (1) am ersten Ort A, wobei eine gewisse Lageabweichung von der Soll-Lage zulässig ist.
2. Ansaugen und Festhalten der Folie (4) auf der der Folie (4) zugewandten Oberfläche des Chip-Auswerfers (6);
3. Ermittlung der Ist-Lage des Chips (1) mittels der Messkamera (9);
4. Bestimmung des Korrekturvektors, der die Abweichung der ermittelten Ist-Lage des Chips (1) von seiner Soll-Lage am Ort A darstellt;
5. Korrekturbewegung des Chip-Auswerfers (6) um den Korrekturvektor; und
6. Entnahme des Chips (1) von der Folie (4).

3. Einrichtung nach Anspruch 2, **dadurch gekennzeichnet, dass** die Verschiebung des Tisches (5) im Schritt 1 unter Berücksichtigung des im Schritt 4 des vorhergehenden, oder eines früheren, Arbeitszyklusses ermittelten Korrekturvektors erfolgt.

4. Einrichtung nach Anspruch 2 oder 3, **dadurch gekennzeichnet, dass** im Schritt 5 anstelle der Korrekturbewegung des Chip-Auswerfers (6) um den im Schritt 4 ermittelten Korrekturvektor eine Korrekturbewegung des Chip-Auswerfers (6) erfolgt, die nebst dem im Schritt 4 ermittelten Korrekturvektor einen weiteren Korrekturvektor berücksichtigt, der ein Mass für allfällige Lageabweichungen der auf dem Substrat (2) bereits plazierten Chips (1) darstellt.

5. Einrichtung nach einem der Ansprüche 1 bis 4, **dadurch gekennzeichnet, dass** für die Korrekturbewegung des Chip-Auswerfers (6) piezoelektrische Antriebe (8; 8a; 8b) vorgesehen sind.

6. Verfahren zur Montage von Halbleiterchips (1) auf einem Substrat (2), wobei die Chips (1) auf einer in einem Rahmen (3) eingespannten Folie (4) an einem ersten Ort A bereitgestellt werden und von einem Chipgreifer (10) vom ersten Ort A zu einem auf dem Substrat (2) befindlichen zweiten Ort transportiert werden, das die folgenden Schritte umfasst:
1. Bereitstellung eines neuen Chips (1) am ersten Ort A, wobei eine gewisse Lageabweichung von der Soll-Lage zulässig ist.
2. Ansaugen und Festhalten der Folie (4) auf der der Folie (4) zugewandten Fläche (15) eines Chip-Auswerfers (6);
3. Ermittlung der Ist-Lage des Chips (1);
4. Bestimmung des Korrekturvektors, der die Abweichung der ermittelten Ist-Lage des Chips (1) von seiner Soll-Lage am Ort A darstellt;
5. Korrekturbewegung des Chip-Auswerfers (6) um den Korrekturvektor; und
6. Entnahme des Chips (1) von der Folie (4).

7. Verfahren nach Anspruch 6, **dadurch gekennzeichnet, dass** die Bereitstellung des Chips (1) im Schritt 1 unter Berücksichtigung des im Schritt 4 des vorhergehenden oder eines früheren, Arbeitszyklusses ermittelten Korrekturvektors erfolgt.

8. Verfahren nach Anspruch 6 oder 7, **dadurch gekennzeichnet, dass** im Schritt 5 anstelle der Korrekturbewegung des Chip-Auswerfers (6) um den im Schritt 4 ermittelten Korrekturvektor eine Korrekturbewegung des Chip-Auswerfers (6) erfolgt, die nebst dem im Schritt 4 ermittelten Korrekturvektor einen weiteren Korrekturvektor berücksichtigt, der ein Mass für allfällige Lageabweichungen der auf dem Substrat (2) bereits plazierten Chips (1) darstellt.

## Claims

1. Apparatus for mounting semiconductor chips (1) on a substrate (2), whereby the semiconductor chips (1) are presented on a foil (4) clamped in a frame (3) at a first location A, with a chip gripper (20) for the transport of the semiconductor chip (1) presented at the first location A to a second location located on the substrate (2), with a movable table (5) for the acceptance of the frame (3), with a chip ejector (6) arranged underneath the foil (4) at the first location A the upper surface (15) of which facing the foil (4) has holes (7) connectable to a vacuum source, as well as a measuring camera (9) directed at the first location A for establishing the position of the presented semiconductor chip (1), **characterized in that** for the correction of a possible position deviation of the presented semiconductor chip (1) from its set position, at least the upper surface (15) of the chip ejector (6) facing the foil (4) is movable in the plane running parallel to the under side of the foil.

2. Apparatus according to claim 1, **characterized in that** in each working cycle at least the following steps can be carried out:
1. Movement of the table (5) for the presentation of a new semiconductor chip (1) at the first location A, whereby a certain position deviation from the set position is permissible.
2. Suction and securing of the foil (4) onto the surface of the chip ejector (6) facing the foil (4);
3. Establishing the actual position of the semiconductor chip (1) by means of the measuring camera (9);
4. Determining the correction vector which represents the deviation of the established actual position of the semiconductor chip (1) from its set position at location A;
5. Corrective movement of the chip ejector (6) by the correction vector, and
6. Removal of the semiconductor chip (1) from the foil (4).

3. Apparatus according to claim 2, **characterized in that** the movement of the table (5) in step 1 takes place in consideration of the correction vector established in step 4 of the previous or an earlier working cycle.

4. Apparatus according to claim 2 or 3, **characterized in that** in step 5, instead of the corrective movement of the chip ejector (6) by the correction vector established in step 4, a corrective movement of the chip ejector (6) takes place which, apart from the correction vector established in step 4, takes a further correction vector into consideration which represents a measure for possible position deviations of the semiconductor chip (1) already placed on the substrate (2).

5. Apparatus according to claims 1 to 4, **characterized in that** piezoelectric drives (8, 8a, 8b) are provided for the corrective movement of the chip ejector (6).

6. Method for mounting semiconductor chips (1) on a substrate (2), whereby the semiconductor chips (1) are presented on a foil (4) clamped in a frame (3) at a first location A and are transported by a chip gripper (10) from the first location A to a second location located on the substrate (2) which comprises the following steps:
1. Presenting a new semiconductor chip (1) at the first location A, whereby a certain position deviation from the set position is permissible.
2. Suction and securing of the foil (4) on the surface (15) of a chip ejector (6) facing the foil (4);
3. Establishing the actual position of the semiconductor chip (1);
4. Determining the correction vector which represents the deviation of the established actual position of the semiconductor chip (1) from its set position at location A;
5. Corrective movement of the chip ejector (6) by the correction vector, and
6. Removal of the semiconductor chip (1) from the foil (4).

7. Method according to claim 6, **characterized in that** the presentation of the semiconductor chip (1) in step 1 takes place under consideration of the correction vector established in step 4 of a previous or an earlier working cycle.

8. Method according to claim 6 or 7, **characterized in that** in step 5, instead of the corrective movement of the chip ejector (6) by the correction vector established in step 4, a corrective movement of the chip ejector (6) takes place which, apart from the correction vector established in step 4, takes a further correction vector into consideration which represents a measure for possible position deviations of the semiconductor chips (1) already placed on the substrate (2).

## Revendications

1. Dispositif pour le montage de puces de semi-conducteurs (1) sur un substrat (2), dans lequel les puces (1) sont mises à disposition sur un film (4) tendu sur un cadre (3) dans un premier endroit A, avec une pince à puces (10) pour le transport de la puce (1) mise à disposition au premier endroit A vers un deuxième endroit situé sur le substrat (2), avec un plateau (5) capable de translation destiné à recevoir le cadre (3), avec un éjecteur de puces (6) disposé au premier endroit A en dessous du film (4), dont la face supérieure (15) orientée vers le film (4) est pourvue d'alésages (7) raccordés à une source de vide, ainsi qu'avec une caméra de mesure (9) orientée vers le premier endroit A pour la détermination de la position de la puce (1) mise à disposition, **caractérisé en ce qu'**en vue de la correction d'un écart éventuel de la position de la puce (1) mise à disposition par rapport à sa position de consigne, la face supérieure (15) de l'éjecteur de puces (1) orientée vers le film (4), au minimum, peut être déplacée dans le plan parallèle à la face inférieure du film.

2. Dispositif selon la revendication 1, **caractérisé en ce que** les étapes suivantes peuvent être exécutées pendant chaque cycle de travail :
1. translation du plateau (5) pour la mise à disposition d'une nouvelle puce (1) au premier endroit A, un certain écart de positionnement par rapport à la position de consigne étant admissible;
2. aspiration et maintien du film (4) sur la surface de l'éjecteur de puces (6) orientée vers le film (4);
3. détermination de la position réelle de la puce (1) au moyen de la caméra de mesure (9);
4. détermination du vecteur de correction représentant l'écart de la position réelle de la puce (1) par rapport à sa position de consigne à l'endroit A;
5. mouvement de correction de l'éjecteur de puces (6) selon le vecteur de correction; et
6. retrait de la puce (1) du film (4).

3. Dispositif selon la revendication 2, **caractérisé en ce que** la translation du plateau (5) pendant l'étape 1 tient compte du vecteur de correction déterminé dans l'étape 4 du cycle de travail précédent ou d'un cycle de travail antérieur.

4. Dispositif selon la revendication 2 ou 3, **caractérisé en ce que** pendant l'étape 5, au lieu du mouvement de correction de l'éjecteur de puces (6) selon le vecteur de correction déterminé dans l'étape 4, l'éjecteur de puces (6) exécute un mouvement de correction qui tient compte non seulement du vecteur de correction déterminé dans l'étape 4, mais aussi d'un autre vecteur de correction représentant la mesure d'éventuelles différences de position des puces (1) déjà mises en place sur le substrat (2).

5. Dispositif selon l'une quelconque des revendications 1 à 4, **caractérisé en ce que** des entraînements piézoélectriques (8; 8a; 8b) sont prévus pour le mouvement de correction de l'éjecteur de puces (6).

6. Procédé pour le montage de puces de semi-conducteurs (1) sur un substrat (2), dans lequel les puces (1) sont mises à disposition sur un film (4) tendu sur un cadre (3) dans un premier endroit A, avec une pince à puces (10) pour le transport de la puce (1) mise à disposition au premier endroit A vers un deuxième endroit situé sur le substrat (2), lequel procédé comprend les étapes suivantes :
1. mise à disposition d'une nouvelle puce (1) au premier endroit A, un certain écart de positionnement par rapport à la position de consigne étant admissible;
2. aspiration et maintien du film (4) sur la surface (15) d'un éjecteur de puces (6) orientée vers le film (4);
3. détermination de la position réelle de la puce (1);
4. détermination du vecteur de correction représentant l'écart de la position réelle de la puce (1) par rapport à sa position de consigne à l'endroit A;
5. mouvement de correction de l'éjecteur de puces (6) selon le vecteur de correction; et
6. retrait de la puce (1) du film (4).

7. Procédé selon la revendication 6, **caractérisé en ce que** la mise à disposition de la puce (1) pendant l'étape 1 tient compte du vecteur de correction déterminé dans l'étape 4 du cycle de travail précédent ou d'un cycle de travail antérieur.

8. Procédé selon la revendication 6 ou 7, **caractérisé en ce que** pendant l'étape 5, au lieu du mouvement de correction de l'éjecteur de puces (6) selon le vecteur de correction déterminé dans l'étape 4, l'éjecteur de puces (6) exécute un mouvement de correction qui tient compte non seulement du vecteur de correction déterminé dans l'étape 4, mais aussi d'un autre vecteur de correction représentant la mesure d'éventuelles différences de position des puces (1) déjà mises en place sur le substrat (2).
